## Europäisches Patentamt

## European Patent Office

## Office européen des brevets

(19)

(11) Veröffentlichungsnummer: **0 357 100**
**A2**

(12) **EUROPÄISCHE PATENTANMELDUNG**

(21) Anmeldenummer: 89201841.7

(22) Anmeldetag: 11.07.89

(51) Int. Cl.5: **G01N 24/08**

(30) Priorität: 15.07.88 DE 3823961

(43) Veröffentlichungstag der Anmeldung:
07.03.90 Patentblatt 90/10

(84) Benannte Vertragsstaaten:
CH DE FR GB IT LI NL SE

(71) Anmelder: **Philips Patentverwaltung GmbH**
**Wendenstrasse 35 Postfach 10 51 49**
**D-2000 Hamburg 1(DE)**

(84) DE

Anmelder: **N.V. Philips' Gloeilampenfabrieken**
**Groenewoudseweg 1**
**NL-5621 BA Eindhoven(NL)**

(84) CH FR GB IT LI NL SE

(72) Erfinder: **Jensen, Jens Dye, Dr.**
**Myermannweg 10**
**D-2000 Hamburg 54(DE)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) **Kernspintomographieverfahren und Kernspintomograph zur Durchführung des Verfahrens.**

(57) Die Erfindung betrifft ein Kernspintomographieverfahren, bei dem zwei schichtselektive Hochfrequenzimpulse die Kernmagnetisierung in einer Schicht beeinflussen. Durch weitere schichtselektive Hochfrequenzimpulse, die zu der genannten Schicht senkrechte Teilschichten anregen, werden in dem streifenförmigen Schnittbereich zwischen der jeweiligen Teilschicht und der Schicht stimulierte Echosignale erzeugt. Die mit den weiteren Hochfrequenzimpulsen verknüpften FID-Signale werden durch ein nachgeschaltetes magnetisches Gradientenfeld unterdrückt. Damit dieses nicht auch die gewünschten stimulierten Echosignale dephasiert, wird zwischen dem ersten und dem zweiten Hochfrequenzimpuls ein magnetisches Graidentenfeld mit gleichem zeitlichen Integral eingeschaltet.

Fig.3

## Kernspintomographieverfahren und Kernspintomograph zur Durchführung des Verfahrens

Die Erfindung betrifft ein Kernspintomographieverfahren, bei dem in Anwesenheit eines homogenen, stationären Magnetfeldes ein erster schichtselektiver Hochfrequenzimpuls und ein zweiter Hochfrequenzimpuls auf einen Untersuchungsbereich einwirken, wonach weitere schichtselektive Impulse auf den Untersuchungsbereich einwirken, die die Kernmagnetisierung in zueinander parallelen Teilschichten anregen, die zu der Schicht senkrecht stehen, und bei dem die im Anschluß an jeden weiteren Hochfrequenzimpuls in der zugehörigen Teilschicht auftretenden stimulierten Echosignale empfangen und einer Fouriertransformation unterzogen werden, sowie einen Kernspintomographen zur Durchführung des Verfahrens.

Ein solches Verfahren ist aus der EP-PS 184 840 bekannt. Damit kann die Kernmagnetisierungsverteilung in einem Untersuchungsbereich mit nur einem einzigen "Schuß" gemessen werden, d.h., mit nur einer Sequenz; deshalb ist die Meßzeit im Vergleich zu den konventionellen Kernspintomographieverfahren mit einer Vielzahl von Sequenzen kurz. Auf der anderen Seite ist die Meßzeit länger als bei den aus der Zeitschrift "Magnetic resonance in medicine" 5, Seiten 563 bis 571, 1987, bekannten Verfahren, bei dem die Daten innerhalb eines Zeitraums von nicht mehr als etwa 40 ms erfaßt werden müssen. Dazu sind magnetische Gradientenfelder mit einem außerordentlich hohen Gradienten erforderlich, die in außerordentlich kurzer Zeit geschaltet werden müssen, wenn ein bestimmtes räumliches Auflösungsvermögen erreicht werden soll. Die damit verbundenen zeitlichen Änderungen der magnetischen Fluß dichte sind mehrfach so groß wie die in verschiedenen Staaten empfohlenen Richtwerte. Da bei dem eingangs erwähnten Verfahren die Meßzeit deutlich länger ist, sind die Anforderungen an die Stärke des Gradientenfeldes und die Schaltgeschwindigkeit wesentlich geringer.

Bei dem eingangs erwähnten bekannten Verfahren wird außer dem erwünschten stimulierten Echosignal durch jeden der weiteren Hochfrequenzimpulse ein mit dem freien Induktionsverfall (free induction decay) verknüpftes sogenanntes FID-Signal erzeugt - und zwar in der gesamten durch diesen Hochfrequenzimpuls angeregten Teilschicht. Dieses unerwünschte FID-Signal wird durch das nach jedem weiteren Hochfrequenzimpuls erzeugte magnetische Gradientenfeld bis zum Beginn des Empfangs des stimulierten Echosignals, im folgenden kurz STE-Signal genannt, allenfalls geringfügig dephasiert. Es wird daher mit dem STE-Signal mitempfangen und fouriertransformiert, wodurch sich in der ermittelten Kernmagnetisierungsverteilung Fehler bzw. im Bild dieser Verteilung Artefakte ergeben.

Aufgabe der vorliegenden Erfindung ist es, ein Verfahren der eingangs genannten Art so auszugestalten, daß das mit jedem der weiteren Hochfrequenzimpulse verbundene FID-Signal unterdrückt wird. Diese Aufgabe wird erfindungsgemäß dadurch gelöst, daß im Anschluß an jeden weiteren Hochfrequenzimpuls und vor dem Empfang des damit verknüpften Kernresonanzsignals ein magnetisches Gradientenfeld zwecks Dephasierung des mit dem Hochfrequenzimpuls verbundenen FID-Signals ein- und ausgeschaltet wird, daß zwischen dem ersten und dem zweiten Hochfrequenzimpuls ein magnetisches Gradientenfeld ein- und ausgeschaltet wird und daß die Gradienten dieser Felder parallel oder antiparallel zueinander verlaufen und ihr zeitliches Integral dem Betrage nach gleich ist. Das FID-Signal wird also dadurch unterdrückt, daß im Anschluß an jeden weiteren Hochfrequenzimpuls und vor dem Empfang des damit verknüpften STE-Signals ein magnetisches Gradientenfeld zwecks Dephasierung des mit diesem Hochfrequenzimpuls verbundenen FID-Signals ein- und ausgeschaltet wird. Die vollständige Dephasierung dieses Signals setzt voraus, daß das zeitliche Integral über das magnetische Gradientenfeld vor dem Empfang des STE-Signales genügend groß ist. - Das magnetische Gradientenfeld im Anschluß an jeden weiteren Hochfrequenzimpuls beeinflußt allerdings auch das STE-Signal. Damit dieses nicht ebenfalls dephasiert wird, wird zwischen dem ersten und dem zweiten Hochfrequenzimpuls ein magnetisches Gradientenfeld mit in gleicher Richtung (oder antiparallel dazu) verlaufendem Gradienten ein-und ausgeschaltet. Dieses magnetische Gradientenfeld bewirkt eine Prädephasierung des STE-Signals, die durch das Ein- und Ausschalten des magnetischen Gradientenfeldes im Anschluß an jeden weiteren Hochfrequenzimpuls bewirkte (re-)Dephasierung kompensiert wird, wenn die zeitlichen Integrale über die beiden magnetischen Gradientenfelder den gleichen Betrag haben. Infolgedessen werden - mit Ausnahme des STE-Signals - alle Komponenten der mit den Hochfrequenzimpulsen verknüpften Kernresonanzsignale unterdrückt.

Bei dem bekannten Verfahren ist der zweite Hochfrequenzimpuls ein nichtselektiver Hochfrequenzimpuls, d.h. er regt nicht nur die Kernmagnetisierung in der zuvor angeregten Schicht an, sondern im gesamten Untersuchungsbereich. Die Anregung der Kernmagnetisierung außerhalb der zuvor bereits angeregten Schicht kann hier die Entstehung von FID-Signalen bzw. - in Verbindung mit den weiteren Hochfrequenzimpulsen - von Spin-Echosignalen zur Folge haben. Diese können zwar durch ein nach dem zweiten Hochfrequenzimpuls ein- und ausgeschaltetes magnetisches Gradienten feld dephasiert werden, jedoch muß die Dephasierung vollständig sein, damit nicht die restlichen Signalkomponenten aus den insgesamt wesentlich größeren Bereichen außerhalb der Schicht eine vergleichbare Größe haben wie das STE-Signal innerhalb der Schicht. Dies läßt sich in weiterer Ausgestaltung der Erfindung dadurch vermeiden, daß der zweite Hochfrequenzimpuls ein schichtselektiver Hochfrequenzimpuls ist und die gleiche Schicht beeinflußt wie der erste Hochfrequenzimpuls. Der zweite Hochfrequenzimpuls beeinflußt bei dieser Ausgestaltung also nicht die Kernmagnetisierung außerhalb der Schicht.

In der Regel wird das STE-Signal in Verbindung mit einem magnetischen Gradientenfeld empfangen, dem sogenannten Lesegradienten. Zur Verbesserung des Signal/Rauschver-Verhältnisses ist dabei vorgesehen, daß die Polarität des Gradienten nach dem Empfang des stimulierten Echosignals umgeschaltet wird und daß die dabei auftretenden rephasierten Echosignale empfangen und ausgewertet werden. Die rephasierten Echosignale können dann zu dem STE-Signal vor oder nach der Fouriertransformation addiert werden, wobei sich die durch Rauschen bedingten statistischen Signalschwankungen verringern.

Das erfindungsgemäße Verfahren sollte innerhalb eines Zeitraums durchgeführt sein, der kleiner ist als die Längsrelaxationszeit der durch die Hochfrequenzimpulse angeregten Protonen. Üblicherweise wird die Frequenz der Hochfrequenzimpulse so gewählt, daß die Wasserstoffprotonen angeregt werden. Bekanntlich besitzen Kerne von in Wasser gebundenen Wasserstoffatomen längere $T_1$-Relaxationszeiten als Kerne von in Lipiden (Fett) gebundenen Wasserstoffatomen. Deshalb kann das erfindungsgemäße Verfahren in den zuerst angeregten Teilschichten nebeneinander die Abbildung von Fett- und wasserhaltigem Gewebe liefern, während von den zuletzt angeregten Teilschichten nur das Wassergewebe dargestellt wird. Dies läßt sich in weiterer Ausgestaltung der Erfindung dadurch vermeiden, daß dem ersten Hochfrequenzimpuls ein frequenzselektiver, die an Fett gebundenen Protonen anregender Hochfrequenzimpuls und diesem nachfolgend die Ein- und Ausschaltung eines magnetischen Gradientenfeldes vorausgeht. Die Mittenfrequenz des frequenzselektiven Hochfrequenzimpulses wird dabei auf die Resonanzfrequenz der an Fett gebundenen Protonen eingestellt. Dadurch wird erreicht, daß die an Fett gebundenen Protonen dephasiert werden und keinen Signalbeitrag liefern können.

In weiterer Ausgestaltung der Erfindung ist vorgesehen, daß bei der Anregung der Teilschichten das Verhältnis zwischen dem mit jedem weiteren Hochfrequenzimpuls einhergehenden magnetischen Gradientenfeld und der Bandbreite des betreffenden Hochfrequenzimpuls variiert wird, so daß unterschiedlich breite Streifen angeregt werden. Dabei lassen sich die besonders schmalen Streifen in den diagnostisch relevanten Bereich legen, so daß dort eine höhere räumliche Auflösung erreicht wird als in anderen Teilen der angeregten Schicht.

Die Erfindung wird nachstehend anhand der Zeichnung näher erläutert. Es zeigen:

Fig. 1 einen Kernspintomographen, mit dem das erfindungsgemäße Verfahren ausführbar ist,

Fig. 2 ein Blockschaltbild eines solchen Gerätes,

Fig. 3 den zeitlichn Verlauf verschiedener Signale bei einer erfindungsgemäßen Sequenz,

Fig. 4 einen quaderförmig angenommenen Untersuchungsbereich und die Lage der darin durch die verschiedenen Hochfrequenzimpulse angeregten Schichten,

Fig. 5 und 6 die zeitlichen Verläufe von Signalen bei verschiedenen Modifikationen des in Fig. 3 dargestellten Verfahrens.

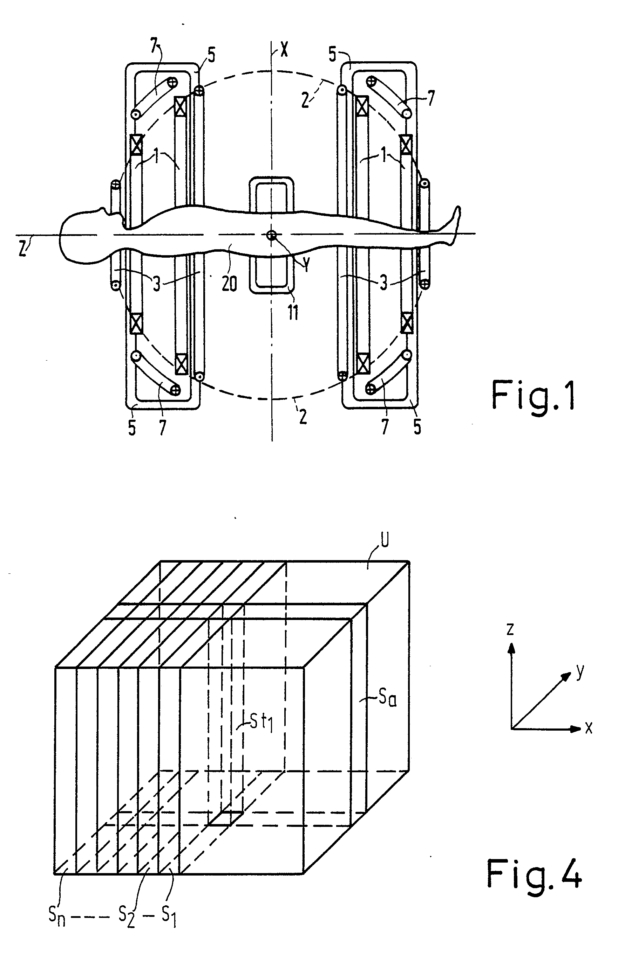

Der in Fig. 1 schematisch dargestellte Kernspintomograph enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die mit den Spulen 7 identisch sein können, die jedoch diesen gegenüber um 90° räumlich versetzt angeordnet sind. Von diesen Spulen 5 sind in Fig. 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordi natenursprung des erwähnten kartesischen x,y,z-Koordinatensystems bildet, nur durch das stationäre homogene Magnetfeld der Spulenanordnung 1 bestimmt. Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. - Im Anschluß an einen oder mehrere Hochfrequenzspule 11 zum Empfangen der durch Kernspinresonanz im Untersuchungsbereich erzeugten Echosignale. Stattdessen könnte aber auch eine gesonderte Hochfrequenzempfangsspule verwendet werden.

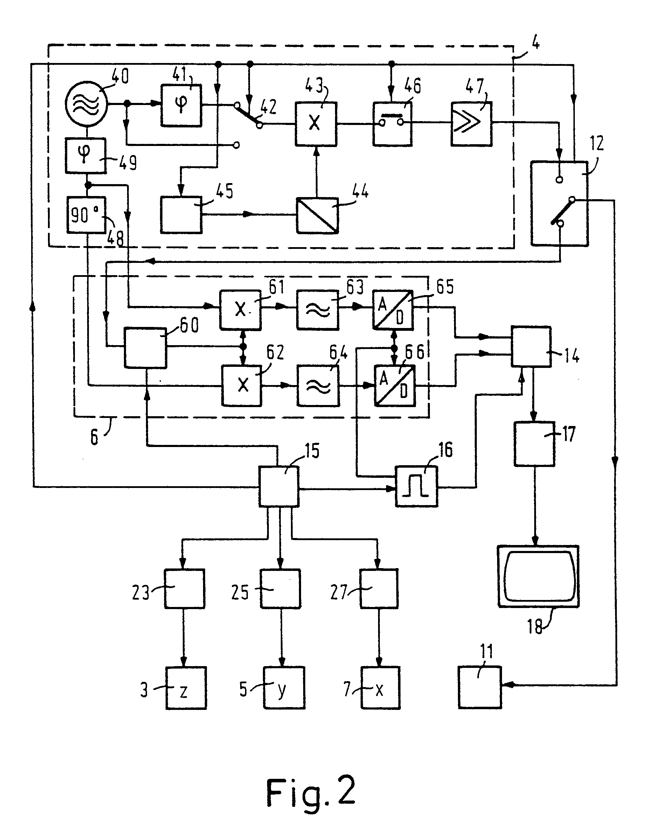

Fig. 2 zeigt ein vereinfachtes Blockschaltbild dieses Kernspintomographen. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzoszillator 40, der Schwingungen mit einer Frequenz gleich der Larmorfrequenz von Wasserstoffprotonen erzeugt. Die Larmorfrequenz f berechnet sich bekanntlich nach der Beziehung f = cB, wobei B die magnetische Flußdichte in dem stationären homogenen Magnetfeld darstellt und c das gyromagnetische Verhältnis, das beispielsweise für Wasserstoffprotonen 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Eingang mit einem digitalen Speicher 45 verbunden ist. Aus dem Speicher 45 wird - gesteuert durch eine Steuereinrichtung 15 - eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenzleistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist·und dem die in der Hochfrequenzspule 11 induzierten, durch Kernspinresonanz hervorgerufenen Echosignale zugeführt werden, wenn die Umschalteinrichtung 12 entsprechend gesteuert ist. Der Verstärker besitzt einen von der Steuereinrichtung 15 gesteuerten Stummschalteingang, über den er gesperrt werden kann, so daß die Verstärkung praktisch Null ist. Der Ausgang des Verstärkers 60 ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90°-Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüber liegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildendenden Schaltung 61..64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die drei Spulenanordnungen 3, 5 und 7 werden von Stromgeneratoren 23, 25 und 27 jeweils mit einem Strom versorgt, dessen zeitlicher Verlauf durch die Steuereinheit 15 steuerbar ist. Die im Speicher 14 gespeicherten Datenworte bzw. Abtastwerte werden einem Rechner 17 zugeführt, der daraus die räumliche Verteilung der Kernmagnetisierung in der untersuchten Schicht ermittelt und die ermittelte Verteilung an einer geeigneten Wiedergabeeinheit, z.B. einem Monitor 18, ausgibt.

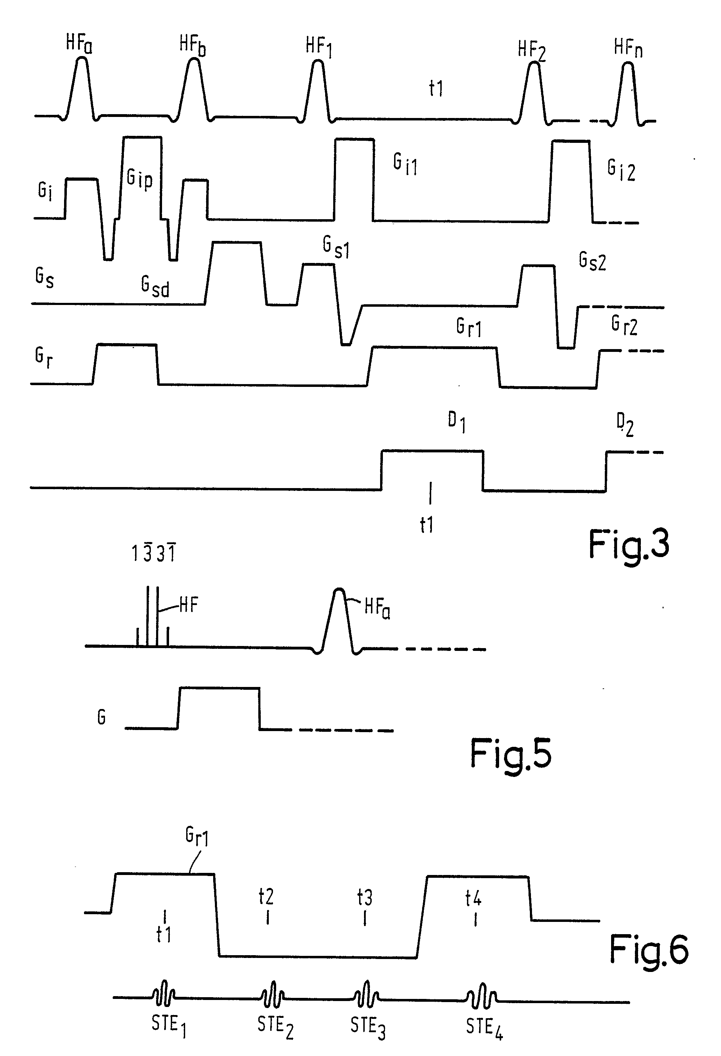

Fig. 3 zeigt den zeitlichen Verlauf der von der Hochfrequenzspule 11 und den Gradientenspulen 3, 5 und 7 erzeugten Signale und die Lage des Meßzeitraumes, währenddessen das Kernresonanzsignal erfaßt wird.

In der ersten Zeile von Fig. 3 ist die zeitliche Lage der Hochfrequenzimpulse dargestellt. Der erste Hochfrequenzim puls $HF_a$ ist ein schichtselektiver Hochfrequenzimpuls, d.h. während dieses Hochfrequenzimpulses ist ein magnetisches Gradientenfeld $G_i$ eingeschaltet, so daß die Kernmagnetisierung nur in einer Schicht beeinflußt wird, deren Lage von der Mittenfrequenz des Hochfre-

quenzimpulses HF$_a$ und deren Dicke von seiner Bandbreite sowie von der Stärke des magnetischen Gradientenfeldes abhängt. In bekannter Weise wird nach dem Hochfrequenzimpuls die Polarität des magnetischen Gradientenfeldes umgeschaltet, so daß das zeitliche Integral über das magnetische Gradientenfeld von der Mitte des Hochfrequenzimpulses bis zum Abschalten des Gradientenfeldes gerade den Wert Null hat.

Fig. 4 zeigt den Untersuchungsbereich U, der hier quaderförmig angenommen ist und die Lage der Schicht S$_a$ deren Kernmagnetisierung durch den schichtselektiven Hochfrequenzimpuls HF$_a$ angeregt wird. Die Schicht S$_a$ erstreckt sich senkrecht zur y-Richtung, wenn der Gradient G$_i$ des magnetischen Gradientenfeldes in y-Richtung verläuft. In diesem Fall müßte die Steuereinheit 15 während des ersten Hochfrequenzimpulses HF$_a$ den Stromgenerator 25 einschalten (vergl. Fig. 2), so daß die Gradientenspulenanordnung 5 (Fig. 1) ein magnetisches Gradiencenfeld G$_y$ erzeugen würde, das mit dem Gradientenfeld G$_i$ identisch ist. Der Gradient während des ersten Hochfrequenzimpulses kann aber auch in einer anderen Richtung verlaufen, beispielsweise in x- oder in z-Richtung oder unter einem von 90° verschiedenen Winkel zu den genannten Richtungen; in letztgenanntem Fall wären während des ersten Hochfrequenzimpulses gleichzeitig alle drei Stromgeneratoren einzuschalten.

Nach dem ersten Hochfrequenzimpuls und vor dem zweiten wird ein magnetisches Gradientenfeld ein- und ausgeschaltet. Dieses Gradientenfeld kann in der gleichen Richtung verlaufen wie zuvor, wie in Fig. 3 durch die Kurve G$_{ip}$ dargestellt. Es könnte auch in einer anderen Richtung verlaufen. Es bewirkt, daß die Kernmagnetisierung in der Schicht S$_a$ dephasiert wird.

Danach folgt ein zweiter schichtselektiver Hochfrequenzimpuls HF$_b$, der die Kernmagnetisierung in der gleichen Schicht beeinflußt wie der erste Hochfrequenzimpuls HF$_a$. Dieser bewirkt, daß in der Schicht S$_a$ die Kernmagnetisierung teilweise in die Richtung des stationären homogenen Magnetfeldes gekippt wird, d.h. in z-Richtung.

Nach dem zweiten Hochfrequenzimpuls und vor dem nächsten wird ein magnetisches Gradientenfeld ein- und ausgeschaltet. Der Gradient dieses Feldes kann in der gleichen Richtung verlaufen wie zuvor, jedoch auch in einer anderen Richtung. In Fig. 3 ist dies durch den zeitlichen Verlauf G$_{sd}$ des magnetischen Gradientenfeldes G$_s$ veranschaulicht, der in x-Richtung verläuft und durch Einschalten des Stromgenerators 27 (Fig. 2) erzeugt wird und mit dem Gradienten G$_x$ identisch ist. Die zuvor in z-Richtung gekippte Kernmagnetisierung kann dieses Gradientenfeld nicht beeinflussen, jedoch die gesamte übrige Kernmagnetisierung, so daß dadurch mit den Hochfrequenzimpulsen HF$_a$ und HF$_b$ verbundene Spin-Echosignale oder FID-Signale aus der Schicht unterdrückt werden.

Danach folgt eine Reihe weiterer schichtselektiver Hochfrequenzimpulse HF1, HF2 ... HF$_n$, vorzugsweise in gleichem Abstand voneinander. Weil sich die Mittenfrequenzen dieser weiteren Hochfrequenzimpulse unterscheiden und weil mit jedem dieser Hochfrequenzimpulse ein magnetisches Gradientenfeld verknüpft ist, dessen Gradient G$_{s1}$, G$_{s2}$ ... (vergl. dritte Zeile von Fig. 3) senkrecht zu dem während der beiden Hochfrequenzimpulse wirksamen Gradienten verläuft, wird die Kernmagnetisierung in zueinander parallelen Teilschichten S$_1$ ... S$_n$ angeregt, die senkrecht zur x-Richtung und senkrecht zu der Schicht S$_a$ verlaufen. Jeder dieser weiteren Hochfrequenzimpulse bewirkt, daß in der durch ihn beeinflußten Schicht ein FID-Signal erzeugt wird und daß in dem streifenförmigen Schnittbereich zwischen der betreffenden Teilschicht und der Schicht S$_a$ ein STE-Signal erzeugt wird. In Fig. 4 ist nur der streifenförmige Schnittbereich bzw. Streifen St$_1$ dargestellt, in dem der erste (HF1) dieser weiteren Hochfrequenzimpulse ein STE-Signal hervorruft. Die übrigen Streifen liegen parallel zu dem Streifen St$_1$ innerhalb der Schicht S$_a$.

Bevor das mit jedem der weiteren Hochfrequenzimpulse HF1...HF$_n$ verknüpfte STE-Signal erfaßt wird, wird nach jedem dieser weiteren Hochfrequenzimpulse noch ein magnetisches Gradientenfeld ein- und ausgeschaltet, was in der zweiten Zeile von Fig. 3 durc die Kurven G$_{i1}$, G$_{i2}$ dargestellt ist. Das zeitliche Integral über dieses magnetische Gradientenfeld vom Einschalten bis zum Ausschalten ist genauso groß wie das zeitliche Integral über das magnetische Gradientenfeld zwischen den beiden Hochfrequenzimpulsen HF$_a$ und HF$_b$ (Kurve G$_{ip}$). Dadurch wird für das jeweilige STE-Signal die dephasierende Wirkung des magnetischen Gradientenfeldes (G$_{ip}$) zwischen den beiden Hochfrequenzimpulsen HF$_a$ und HF$_b$ gerade kompensiert. Hingegen wird das FID-Signal in der betreffenden Teilschicht durch das magnetische Gradientenfeld (G$_{i1}$) vollständig dephasiert. Nach dem Ausschalten des magnetischen Gradientenfeldes kann also nur noch ein STE-Signal aus dem zugehörigen Streifen (z.B. St$_1$) empfangen werden.

Um die STE-Signale aus den einzelnen Streifen empfangen zu können, wird zwischen den beiden Hochfrequenzimpulsen HF$_a$, HF$_b$ ein magnetisches Gradientenfeld G$_r$ mit einem Gradienten ein- und ausgeschaltet (4. Zeile), dersenkrecht zu den Gradienten G$_i$ und G$_s$ während der verschiedenen Hochfrequenzimpulse verläuft, der also in Längsrichtung der Streifen (St$_1$) verläuft, bei dem Beispiel nach Fig. 4 also in z-Richtung. Die STE-Signale entstehen, wenn die sogenannte Gradientenbedingung erfüllt ist, d.h. wenn nach jedem der weiteren Impulse HF1, HF2 usw. das magnetische Gradientenfeld $G_r$ (Kurven $G_{r1}$, $G_{r2}$ usw.) derart ein- und ausgeschaltet wird, daß das zeitliche Integral vom Einschalten bis zum Auftreten des STE-Signals (zur Zeit $t_1$ ) genauso groß ist wie das zeitliche Integral über das Lesegradientenfeld zwischen den Hochfrequenzimpulsen $HF_a$ und $HF_b$.

Das in jedem der erwähnten, durch die Schicht $S_a$ und die Teilschicht $S_1...S_n$ definierten Streifen erzeugte STE-Signal wird dadurch erfaßt, daß die Steuereinrichtung 15 ebenfalls um den Zeitpunkt des Auftretens des STE-Signals herum den Taktgenerator 16 freigibt (derzeitliche Verlauf des Freigabesignals D1, D2 ist in der fünften Zeile von Fig. 3 dargestellt), so daß das von der Hochfrequenzspulenanordnung empfangene STE-Signal durch die Analog-Digital-Wandler 65, 66 digitalisiert und in den Speicher 14 eingelesen wird, wonach ein in der Einheit 17 eine eindimensionale Fouriertransformation (jeweils über die Abtastwerte eines einzigen STE-Signals) durchgeführt wird. Diese Fouriertransformation liefert die Kernmagnetisierungsverteilung in Richtung jeweils eines Streifens.

Wie bereits erwähnt, sollte der Abstand des letzten Hochfrequenzimpulses $HF_n$ vom ersten Hochfrequenzkimpuls $HF_a$ kleiner sein als die Längsrelaxationszeit $T_1$, vorzugsweise klein gegenüber $T_1$. Wenn die Aufeinanderfolge der Hochfrequenzimpulse diese Bedingung für die Längsrelaxationszeit von an Wasser gebundenen Wasserstoffprotonen erfüllt, kann die Bedingung für an Fett gebundene Wasserstoffprotonen gleichwohl nicht erfüllt sein, weil die Längsrelaxationszeit für Fett wesentlich kürzer ist als für Wasser. Dies hat zur Folge, daß die mit den ersten der weiteren Hochfrequenzimpulse (z.B. mit HF1) verknüpften STE-Signale Signalkomponenten enthalten, während die von den letzten Hochfrequenzimpulsen (z.b. $HF_n$) herrührenden STE-Signale ausschließlich durch die an Wasser gebundenen Wasserstoffprotonen bestimmt sind. Dies kann zur Fehldeutung aus diese Weise erzeugten Kernspintomogramme führen.

Solche Fehldeutungen lassen sich vermeiden, wenn von vornherein die vom Fettgewebe herrührenden Signalanteile unterdrückt werden. Gemäß Fig. 5 wird zu diesem Zweck dem ersten Hochfrequenzimpuls ein frequenzselektiver 90°-Hochfrequenzimpuls $HF_0$ in Form eines binomialen $1-\overline{3}-3-\overline{1}$-Hochfrequenzimpulses vorausgeschickt. Ein solcher binomialer Hochfrequenzimpuls besteht bekanntlich aus einer Folge von Teilpulsen, deren zugeordnete Flipwinkel im gleichen Verhältnis zueinander stehen wie die Binomialkoeffizienten, wobei jeder Teilpuls die Kernmagnetisierung mit entgegengesetztem Drehsinn dreht wie der vorausgehende Teilpuls. Die Mittenfrequenz der Teilpulse entspricht exakt der Larmorfrequenz von Wasser, die um etwa 3,3 ppm von der Larmorfrequenz von Fett abweicht. Deshalb hebt sich die Wirkung dieser Teilpulse für wasserhaltiges Gewebe auf, d.h. solches Gewebe wird durch den binomialen Hochfrequenzimpuls nicht angeregt. Hingegen sind die zeitlichen Abstände der Teilpulse voneinander so gewählt, daß sie für Fett insgesamt wie ein 90°-Hochfrequenzimpuls wirken. Somit ist der binomiale Hochfrequenzimpuls ein frequenzselektiver Hochfrequenzimpuls. Die durch ihn im Fettgewebe innerhalb des Untersuchungsbereiches angeregte Kernmagnetisierung wird durch ein nachfolgendes magnetisches Gradientenfeld G (zweite Zeile von Fig. 5 dephasiert. Infolgedessen haben die von den nachfolgenden Hochfrequenzimpulsen $HF_a$, $HF_b$, HF1 usw. erzeugten Kernresonanzsignale keine Signalkomponenten, die von Fettgewebe herrühren, und das damit erzeugte Bild der Kernmagentisierungsverteilung ist ein reines Wasserbild. Wahlweise können zur Saturierung des Festtsignales auch andere frequenzselektive Impulse eingesetzt werden.

Das Signal/Rausch-Verhältnis eines mit dem in Fig. 3 skizzierten Verfahren hergestellten Bildes der Kernmagnetisierungsverteilung läßt sich verbessern, wenn neben dem ersten STE-Signal auch mehrfach rephasierte STE-Signale zur Bildgebung herangezogen werden. Zu diesem Zweck wird das zum Auslesen des ersten STE-Signals $STE_1$ dienende magnetische Gradientenfeld (Kurve $G_{r1}$ in seiner Polarität umgekehrt, wenn das zeitliche Integral über dieses Feld (von dem zugehörigen Hochfrequenzimpuls HF1 an) doppelt so groß ist wie das entsprechende Integral im Intervall zwischen den beiden Hochfrequenzimpulsen $HF_a$ und $HF_b$. Zum Zeitpunkt t2, an dem das Zeitintegral über den Lesegradienten im Intervall von t1 (dem Auftreten des ersten stimulierten Echosignals $STE_1$) gerade den Wert Null erreicht, ergibt sich ein weiteres, rephasiertes stimulisiertes Echosignal $STE_2$. Ein drittes STE-Signal ($STE_3$) tritt zum Zeitpunkt t3 auf, zu dem das Zeitintegral über dieses Feld (vom Hochfrequenzimpuls $HF_a$ an) den Wert Null erreicht. Ein viertes Signal ergibt sich, wenn danach die Polarität des Gradientenfeldes erneut umgeschaltet wird; die Umschaltung soll erfolgen, wenn das zeitliche Integral über den negativen Teil des Lesegradienten $G_r$ doppelt so groß ist wie das zeitliche Integral über $G_{r1}$. Es ergibt sich dann ein viertes Signal zur Zeit t4, wenn das zeitliche Integral über das Gradientenfeld von t3 bis t4 gerade den Wert Null hat. Dies kann gebenenfalls noch weiter fortgesetzt werden.

Durch Summierung der auf diese Weise erhaltenen STE-Signale (vor oder nach der Fouriertransformation), die alle von dem Streifen $St_1$ herrühren, wird das Signal/Rausch-Verhältnis verbessert. Allerdings vergrößert sich dadurch die zum Auslesen eines Streifens benötigte Zeit, so daß damit nicht so viele Streifen untersucht werden können, wie bei dem in Fig. 3 skizzierten Verfahren.

Gemäß Fig. 3 verläuft der Gradient des magnetischen Gradientenfeldes bei den beiden ersten Hochfrequenzimpulsen $HF_a$ und $HF_b$ in derselben Richtung, so daß die gleiche Schicht dadurch angeregt wird. Es ist aber auch möglich, stattdessen beim zweiten Hochfrequenzimpuls $HF_b$ ein magnetisches Gradientenfeld mit einem in Richtung des Lesegradienten $G_r$ verlaufenden Gradienten einzuschalten. Dadurch wird in einfacher Weise eine Begrenzung des Bildausschnittes erreicht.

Wegen der Längsrelaxation ist die Amplitude der zuletzt (z.B. durch $HF_n$) erzeugten STE-Signale kleiner als die Amplitude der zuerst erzeugten Signale; bekanntlich nimmt die Amplitude nach einer Exponentialfunktion ab, mit der Längsrelaxationszeit $T_1$ als Zeitkonstanten. In einem Kernspintomogramm erscheinen daher die zuletzt ausgelesenen Streifen dunkler als die zuerst ausgelesenen. Dies läßt sich vermeiden, wenn die Flipwinkel (das ist der Winkel, um den die Kernmagnetisierung durch den betreffenden Hochfrequenzimpuls gekippt wird) der weiteren Hochfrequenzimpulse nach einer Exponentialfunktion ansteigt, so daß alle STE-Signale etwa die gleiche Amplitude haben und nur der letzte Hochfrequenzimpuls einen Flipwinkel von 90° aufweist. Es ergibt sich dann ein gleichmäßiges Bild, wobei allerdings das Signal/Rauschverhältnis der zuerst ausgelesenen Streifen schlechter ist als bei einem Bild, bei dem sämtliche Impulse HF1...$HF_n$ 90°-Hochfrequenzimpulse sind. Die beiden ersten Hochfrequenzimpulse $HF_a$ und $HF_b$ sollten ohnehin 90°-Hochfrequenzimpulse sein.

Die $T_1$-Abhängigkeit der STE-Signale kann zur Messung der Relaxationszeit $t_1$ ausgenutzt werden. Dies ist auf zwei verschiedene Arten möglich:

a) Das Verfahren nach Fig. 3 wird wenigstens zweimal durchgeführt, wobei die Teilschichten $S_1$ ...$S_n$ beim zweiten Mal in einer anderen Reihenfolge angeregt werden als beim ersten Mal. Dies hat zur Folge, daß in jedem der Streifen die Kernmagnetisierung mit unterschiedlicher $T_1$-Wichtung erfaßt wird. Für die Bildpunkte innerhalb eines jeden Streifens läßt sich damit eine $T_1$-Berechnung durchführen.

b) Bei ausreichender Signalintensität läßt sich eine $T_1$-Abschätzung auch bei einmaliger Ausführung des Verfahrens nach Fig. 3 durchführen, wenn nach den beiden Hochfrequenzimpulsen $HF_a$ und $HF_b$ die Schichten nicht nur durch jeweils einen einzigen Hochfrequenzimpuls angeregt werden, sondern durch wenigstens zwei im zeitlichen Abstand, von denen zumindest der erste kein 90°-Hochfrequenzimpuls sein darf, damit die Kernmagnetisierung in dem zugehörigen Streifen durch den ersten Impuls nicht vollständig, sondern nur teilweise ausgelesen wird. Die Signalinformation der einzelnen Streifen läßt sich damit stückweise auslesen, mit jeweils fortgeschrittener $T_1$-Wichtung, woraus sich $T_1$ berechnen läßt.

## Ansprüche

1. Kernspintomographieverfahren, bei dem in Anwesenheit eines homogenen stationären Magnetfeldes ein erster schichtselektiver Hochfrequenzimpuls ($HF_a$) und ein zweiter Hochfrequenzimpuls ($HF_b$) auf eine Schicht ($S_a$) eines Untersuchungsbereiches einwirken, wonach weitere schichtselektive Impulse ($HF_1$ ... $HF_n$) auf den Untersuchungsbereich einwirken, die die Kernmagnetisierung in zueinander parallelen Teilschichten ($S_1$ ... $S_n$) anregen, die zu der Schicht ($S_a$) senkrecht stehen, und bei dem die im Anschluß an jeden weiteren Hochfrequenzimpulse in der zugehörigen Teilschicht auftretenden stimulierten Echosignale empfangen und einer Fouriertransformation unterzogen werden, dadurch gekennzeichnet, daß im Anschluß an jeden weiteren Hochfrequenzimpuls ($HF_1$ ... $HF_n$) und vor dem Empfang des damit verknüpften stimulierten Echosignals ein magnetisches Gradientenfeld (z.B. $G_{i1}$) zwecks Dephasierung des mit dem Hochfrequenzimpuls verbundenen FID-Signals ein- und ausgeschaltet wird, daß zwischen dem ersten und dem zweiten Hochfrequenzimpuls ($HF_a$, $HF_n$) ein magnetisches Gradientenfeld $G_{ip}$ ein- und ausgeschaltet wird und daß die Gradienten dieser Felder parallel oder antiparallel zueinander verlaufen und ihr zeitliches Integral dem Betrage nach gleich ist.

2. Verfahren nach Anspruch 1, dadurch gekennzeichnet, daß der zweite Hochfrequenzimpuls ($HF_b$) ein schichtselektiver Hochfrequenzimpuls ist.

3. Verfahren nach Anspruch 2, dadurch gekennzeichnet, daß der zweite Hochfrequenzimpuls ($HF_b$) die gleiche Schicht ($S_a$) beeinflußt wie der erste Hochfrequenzimpuls.

4. Verfahren nach Anspruch 2, dadurch gekennzeichnet, daß die durch den zweiten Hochfrequenzimpuls ($HF_b$) beeinflußte Schicht senkrecht zu der durch der ersten Hochfrequenz ($HF_b$) beeinflußten Schicht ($S_a$) und senkrecht zu den Teilschichten ($S_1$ ... $S_n$) verläuft.

5. Verfahren nach einem der Ansprüche 1 bis 4, wobei das Echosignal in Anwesenheit eines magnetischen Gradientenfeldes empfangen wird, dadurch gekennzeichnet, daß die Polarität des Gradienten ($G_r$) nach dem Empfang des stimulierten Echosignals ($STE_1$) umgeschaltet wird und daß die danach auftretenden rephasierten Echosignale ($STE_2$ ... $STE_4$) empfangen und ausgewertet werden.

6. Verfahren nach einem der vorhergehenden Ansprüche, dadurch gekennzeichnet, daß dem ersten Hochfrequenzimpuls (HF$_a$) ein frequenzselektiver, die an Fett gebundenen Wasserstoffprotonen anregender Hochfrequenzimpuls (HF$_o$) und diesem nachfolgend die Ein- und Ausschaltung eines magnetischen Gradientenfeldes (G) vorausgeht (Fig. 5).

7. Verfahren nach einem der vorhergehenden Ansprüche, dadurch gekennzeichnet, daß die Teilschichten mindestens zweimal mit unterschiedlichem zeitlichen Abstand zwischen dem ersten Hochfrequenzimpuls und dem Hochfrequenzimpuls für die betreffende Teilschicht angeregt werden und daß aus der unterschiedlichen Kernmagnetisierung längs der durch die Teilschichten und die Schicht definierten Streifen die Längsrelaxationszeit bestimmt wird.

8. Verfahren nach einem der Ansprüche 1 bis 7, dadurch gekennzeichnet, daß bei der Anregung der Teilschichten das Verhältnis zwischen dem mit jedem weiteren Hochfrequenzimpuls einhergehenden magnetischen Gradientenfeld und der Bandbreite des betreffenden Hochfrequenzimpuls variiert wird, so daß unterschiedlich breite Streifen angeregt werden.

9. Anordnung zur Durchführung des Verfahrens nach einem der Ansprüche 1 bis 8 mit einem Magneten (1) zur Erzeugung eines stationären homogenen Magnetfeldes, einer Spulenanordnung (11) zur Erzeugung von hochfrequenten Magnetfeldern und mit Gradientenspulen (3, 5, 7) zur Erzeugung von in Richtung des homogenen stationären Magnetfeldes verlaufenden Magnetfeldern mit einem in der gleichen Richtung oder senkrecht dazu verlaufenden Gradienten sowie mit einer Steuereinheit (15) zur Steuerung der Hochfrequenzspule (11) und der Gradientenspulenanordnung (3, 5, 7), dadurch gekennzeichnet, daß die Steuereinheit (15) die Hochfrequenzspulenanordnung (11) und die Gradientenspulenanordnung (3, 5, 7) derart steuert, daß zwischen dem ersten und dem zweiten Hochfrequenzimpuls sowie nach jedem weiteren Hochfrequenzimpuls ein magnetisches Gradientenfeld ein- und ausgeschaltet wird, wobei das zeitliche Integral vom Einschalten bis zum Ausschalten jeweils den gleichen Wert hat.

Fig.1

Fig.4

1-Ⅲ-PHD 88-142

Fig.2

Fig.3

Fig.5

Fig.6

3-III-PHD 88-142